# EUROPEAN PATENT SPECIFICATION

(11) **EP 2 940 801 B1**
(45) Date of publication and mention of the grant of the patent: **18.03.2020**
(21) Application number: 13883345.4
(22) Date of filing: 13.12.2013
(51) Int. Cl.: H01R 13/00, H01R 13/66, H01R 12/58, G07C 5/08, H01R 12/72, H01R 12/73, H05K 3/36, H05K 1/14, H05K 1/18

(54) **PLUG**
STECKER
FICHE

(43) Date of publication of application: 04.11.2015
(73) Proprietor: Huawei Device Co., Ltd., Dongguan, Guangdong 523808 (CN)
(72) Inventor: TU, Jin, Shenzhen Guangdong 518129 (CN); CHEN, Yu, Shenzhen Guangdong 518129 (CN); BAO, Haisen, Shenzhen Guangdong 518129 (CN)
(74) Representative: Thun, Clemens
(86) International application number: PCT/CN2013/089391
(87) International publication number: WO 2015/085579

(56) References cited:
- EP-A2- 0 810 696
- EP-A2- 2 077 605
- CN-A- 1 474 481
- CN-A- 103 067 763
- CN-U- 202 454 060
- CN-Y- 2 405 322
- CN-Y- 2 577 461
- CN-Y- 2 577 461
- CN-Y- 201 238 124
- JP-A- H11 260 487
- US-A- 4 652 066
- US-A1- 2007 087 586
- US-A1- 2007 238 330

## Description

### TECHNICAL FIELD

The present invention relates to the field of vehicle testing, and in particular to a plug.

### BACKGROUND

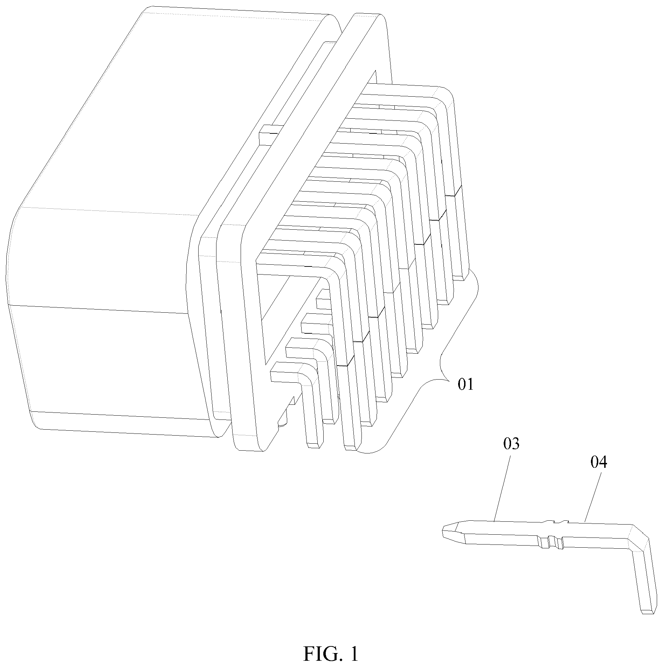

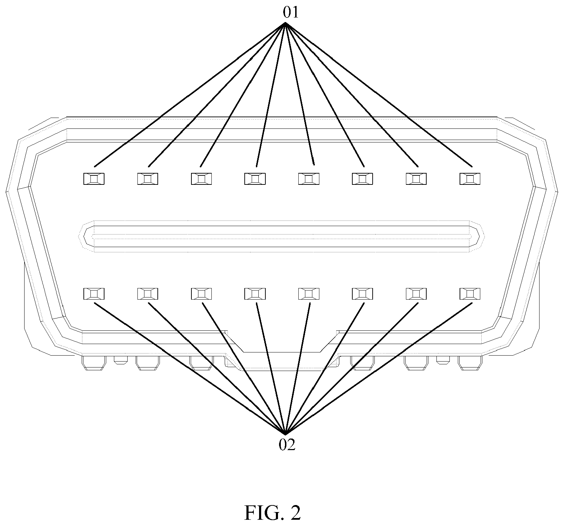

An on-board diagnostics II (OBD II) plug is a connector that uses a dedicated data line interface between an automobile and an on-board diagnostics system and is a standard device in the automobile industry, and has very wide application in the automobile testing industry. In a current market, a type of OBD II plug is provided, where FIG. 1 is a schematic diagram of composition of an OBD II plug according to the prior art, and FIG. 2 is a main view of the OBD II plug according to the prior art. As shown in FIG. 2, 16 male pins of the OBD II plug are divided into a first row 01 and a second row 02 and arranged according to manners shown in FIG. 1 and FIG. 2. As shown in FIG. 1, a first end 03 of each male pin of the 16 male pins is clamped to a slot, a second end 04 of each male pin is bent, and it can be seen from FIG. 1 that, much space is wasted because a male pin located in the first row 01 is bent, thereby affecting an overall size of a printed circuit board assembly.
For example, US 2007/0238330A1 refers to an electrical connector having a first end for fitting with another connector and a second end for connecting to a board. The connector comprises an insulative housing, a number of contacts and a metal shield enclosing the insulative housing. The insulative housing includes a tongue plate with a number of passageways defined therein for receiving the contacts. The contacts are arranged side by side in the first end and arranged in three parallel rows in the second end. The contacts include signal contact pairs and grounding contacts disposed adjacent to and separating the signal contact pairs. Each signal contact pair includes a first signal contact and a second signal contact being substantially in equal length of the first signal contact.

Further, CN 2577461 Y refers to an electric connector, which comprises an insulating shell, a first conductive terminal group, a second conductive terminal group, and two positioning elements, wherein, a body and an upper and a lower inserting parts connected with the body are formed on the insulating shell; each of the first conductive terminal group and the second conductive terminal group comprises a plurality of conductive terminals; each conductive terminal is provided with a first contact part and a second contact part; the first contact part of each of the first conductive terminal group and the second conductive terminal group is respectively contained and fixed in a corresponding terminal containing groove of the two inserting parts; the second contact part can penetrate through a corresponding terminal perforation and is exposed out of the body; the electric connector can be used for inserting a plurality of coupling electric connectors so as to be electrically connected with a circuit basal plate; a stacking type design is adopted, so the area of the circuit basal plate can not be increased.

Further, EP 0 810 696 A2 refers to a printed circuit board connector including a housing to be fitted to a mating connector, and a plurality of conductive terminals having one end portions projecting into the interior of the housing so as to be connected to the mating connector, and the other end portions projecting outwardly from the housing. Alignment correction ribs are formed integrally on an outer surface of the housing in corresponding relation to the conductive terminals, and an alignment correction guide groove for fittingly receiving the associated conductive terminal is formed between any two adjacent ones of the alignment correction ribs. Each of the conductive terminals is bent in a direction of mounting on a printed circuit board when fitting it into the alignment correction guide groove.

Further, US 2007/0087586A1 refers to a non-volatile memory cell including a switchable resistor memory element in series with a switch device. An array of such cells may be programmed using only positive voltages. A method for programming such cells also supports a direct write of both 0 and 1 data states without requirement of a block erase operation, and is scalable for use with relatively low voltage power supplies. A method for reading such cells reduces read disturb of a selected memory cell by impressing a read bias voltage having a polarity opposite that of a set voltage employed to change the switchable resistor memory element to a low resistance state.

Such programming and read methods are well suited for use in a three-dimensional memory array formed on multiple levels above a substrate, particularly those having extremely compact array line drivers on very tight layout pitch.

Further, CN 202454060U refers to a wireless transmission device for on-board diagnostic equipment. The wireless transmission device is a joint electrically inserted in the on-board diagnostic equipment and comprises a male plug, a shell, an OBD (On-Board Diagnostic) interface circuit board and a communication circuit board, wherein the male plug is provided with a plane part, on which a plurality of fixed parts and a plurality of inserting holes are formed; the OBD interface circuit board is parallelly arranged at the front face of the plane part and electrically and vertically connected with a plurality of ejector pins; the ejector pins are inserted in the inserting holes; the communication circuit board is parallelly arranged at the front face of the OBD interface circuit board and electrically communicated with the OBD interface circuit board; a wireless communication module is parallelly bonded at the front face of the communication circuit board; the shell is provided with a plurality of shell fixing pieces corresponding to the fixed parts; and the shell is fixed on the fixed parts by the shell fixing pieces and fixed together with the plane part of the male plug in a buckled way.

Documents US4652066A and EP2077605A2 disclose connectors provided with terminals soldered to a corresponding PCB.

### SUMMARY

Embodiments of the present invention provide a plug, which reduces a volume of the printed circuit board assembly.

To achieve the foregoing objective, the following technical solutions are used in the embodiments of the present invention:

In a first aspect a plug comprising a plug body is provided,
- wherein a first row of slots and a second row of slots are disposed on the plug body, and the first row and the second row are parallel; and the plug further comprises first pins in one-to-one correspondence with the first row of slots and second pins in one-to-one correspondence with the second row of slots; wherein
- the first pin comprises:
   ∘ a first straight portion, a second straight portion, and a bent portion, wherein the bent portion connects the first straight portion to the second straight portion, so that the first pin is L-shaped,
   ∘ wherein the first straight portion of the first pin is embedded in a slot, in a corresponding position, of the first row of slots, and the second straight portion is configured to connect to a first printed circuit board , PCB; and
- the second pin comprising:
   ∘ a first straight portion, a second straight portion, a third straight portion, a fourth straight portion, a first bent portion, a second bent portion and a third bent portion, wherein the first bent portion connects the first straight portion to the second straight portion, the second bent portion connects the second straight portion to the third straight portion and the third bent portion connects the third straight portion to the fourth straight portion, so that the second pin is stair-shaped,
   ∘ wherein the first straight portion of the second pin is embedded in a slot, in a corresponding position, of the second row of slots, and
      the fourth straight portion of the second pin is configured to connect to the first PCB and is parallel to the second straight portion of the first pin,
      wherein the second straight portion of the first pin has an inner side facing the plug body and an outer side facing away from the plug body and the fourth straight portion of the second pin has an inner side facing the outer side of the second straight portion of the first pin and an outer side facing away from the plug body.

In a first implementation form of the first aspect clamping slots in one-to-one correspondence with the second row of slots are further disposed on the plug body, and the clamping slot is configured to correct a position deviation of the second pin.

In a second aspect a printed circuit board assembly is provided comprising:
the plug according to the first aspect or its implementation form; and
a first printed circuit board PCB, wherein
the first PCB is configured to connect to the second straight portion of the first pin of the plug and connect to the fourth straight portion of the second pin of the plug.

In a first implementation form of the second aspect the printed circuit board assembly further comprises a second PCB, wherein
the second PCB is connected to the first PCB by using a connector, and the second pin of the plug is located between the first PCB and the second PCB.

In a second implementation form of the second aspect one end of the second PCB is closely adjacent to the plug body of the plug.

### BRIEF DESCRIPTION OF DRAWINGS

To describe the technical solutions in the embodiments of the present invention or in the prior art more clearly, the following briefly introduces the accompanying drawings required for describing the embodiments or the prior art. Apparently, the accompanying drawings in the following description show merely some embodiments of the present invention, and a person of ordinary skill in the art may still derive other drawings from these accompanying drawings without creative efforts.
FIG. 1 is a schematic diagram of composition of an OBD II plug according to the prior art;
FIG. 2 is a main view of an OBD II plug according to the prior art;
FIG. 3 is a schematic diagram of composition of a plug according to Embodiment 1 of the present invention;
FIG. 4 is a main view of a plug body according to Embodiment 1 of the present invention;
FIG. 5 is a schematic diagram of a size of a plug body according to Embodiment 1 of the present invention;
FIG. 6 is a schematic diagram of sizes of a first pin and a second pin according to Embodiment 1 of the present invention;
FIG. 7 is a schematic diagram of a first pin according to Embodiment 1 of the present invention;
FIG. 8 is a schematic diagram of a second pin according to Embodiment 1 of the present invention;
FIG. 9 is a cross-sectional view of a plug according to Embodiment 1 of the present invention;
FIG. 10 is a schematic diagram of composition of a plug body according to Embodiment 1 of the present invention;
FIG. 11 is a schematic diagram of composition of another plug according to Embodiment 1 of the present invention; and
FIG. 12 is a schematic diagram of composition of a printed circuit board assembly according to Embodiment 2 of the present invention.

### DESCRIPTION OF EMBODIMENTS

### Embodiment 1

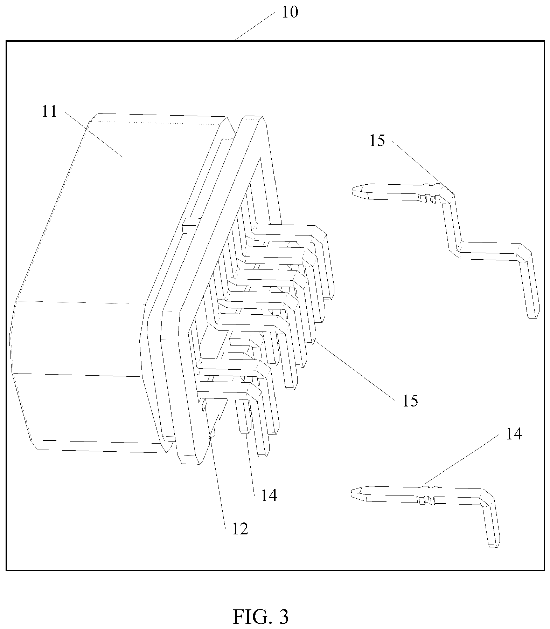

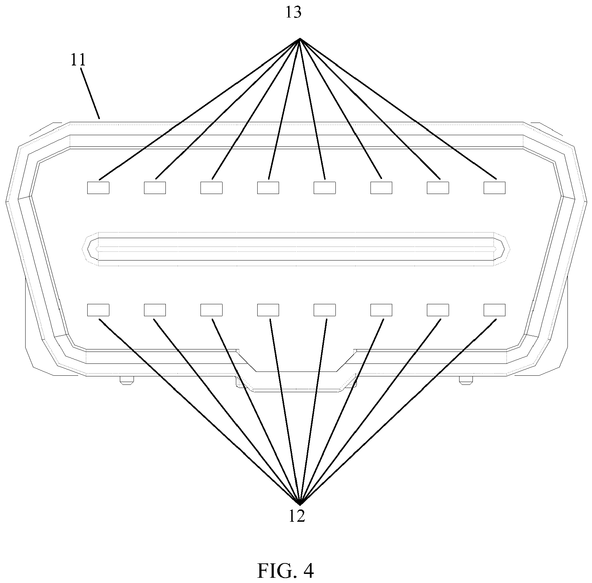

Embodiment 1 of the present invention provides a plug 10. FIG. 3 is a schematic diagram of composition of the plug 10 according to the embodiment of the present invention, and the plug 10 shown in FIG. 3 may include: a plug body 11. FIG. 4 is a main view of the plug body 11 according to the embodiment of the present invention, and a first row of slots 12 and a second row of slots 13 are disposed on the plug body 11 shown in FIG. 4, where the first row and the second row are parallel. The plug 10 shown in FIG. 3 further includes first pins 14 in one-to-one correspondence with the first row of slots 12 and second pins 15 in one-to-one correspondence with the second row of slots 13.

The first pin 14 is L-shaped, one end of the first pin 14 is embedded in a slot, in a corresponding position, of the first row of slots 12, and the other end is configured to connect to a first printed circuit board (Printed Circuit Board, PCB).

The second pin 15 is stair-shaped, one end of the second pin 15 is embedded in a slot, in a corresponding position, of the second row of slots 13, and the other end is configured to connect to the first PCB, is parallel to the end, which is connected to the first PCB, of the first pin 14, and is located on an outer side of the end, which is connected to the first PCB, of the first pin 14.

A stair shape of the second pin 15 may be obtained by bending a pin for two or more times. Compared with a pin in the prior art, the second pin 15 obtained after being bent for two or more times may save a large amount of space. In this way, the large amount of space saved by the second pin 15 may be used to dispose a second PCB of a printed circuit board assembly, so that a volume of the printed circuit board assembly is reduced.

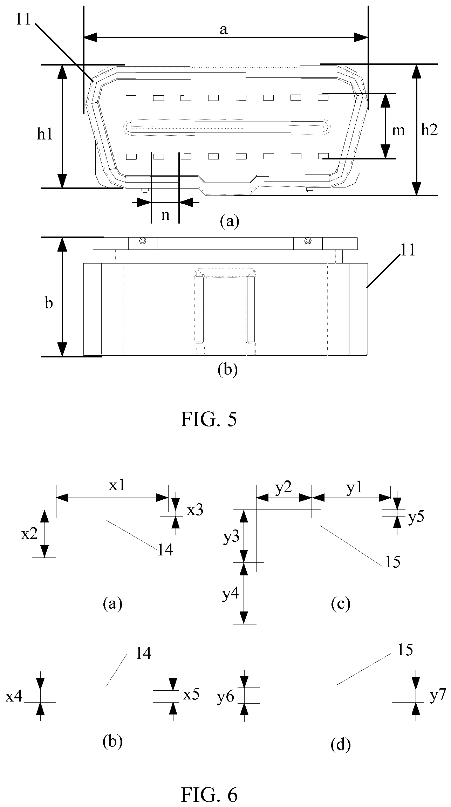

Exemplarily, in the embodiment of the present invention, according to what is stipulated in an OBD II protocol and referring to FIG. 5, a size of the plug body 11 may specifically be that: referring to a main view of the plug body 11 shown in FIG. 5(a), it may be known that a length a of the plug body 11 meets that: a=41.34 millimeters; referring to a bottom view of the plug body 11 shown in FIG. 5(b), it may be known that a width b of the plug body 11meets that: b=17.25 millimeters; and referring to the main view of the plug body 11 shown in FIG. 5(a), it may be known that heights h1 and h2 of the plug body 11 meet that: h1=17.90 millimeters, and h2=19.00 millimeters.

Exemplarily, in the embodiment of the present invention, according to what is stipulated in the OBD II protocol, referring to FIG. 5, and referring to the main view of the plug body 11 shown in FIG. 5(a), it may be known that a distance m between the first row of slots 12 and the second row of slots 13 meets that: m=8.60 millimeters. Referring to the main view of the plug body 11 shown in FIG. 5(a), it may be known that a distance n between every two adjacent slots of the first row of slots 12 and a distance n between every two adjacent slots of the second row of slots 13 both meet that: n=4.00 millimeters.

Exemplarily, in the embodiment of the present invention, according to what is stipulated in the OBD II protocol and referring to a main view of the first pin 14 shown in FIG. 6(a) and a top view of the first pin 14 shown in FIG. 6(b), it may be known that a size of the first pin 14 may be that: x1=14.35 millimeters, x2=6.10 millimeters, x3=0.80 millimeters, x4=1.60 millimeters, and x5=1.50 millimeters.

Exemplarily, in the embodiment of the present invention, according to what is stipulated in the OBD II protocol and referring to a main view of the second pin 15 shown in FIG. 6(c) and a top view of the second pin 15 shown in FIG. 6(d), it may be known that a size of the second pin 15 may be that: y1=10.10 millimeters, y2=7.05 millimeters, y3=6.80 millimeters, y4=7.90 millimeters, y5=0.80 millimeters, y6=1.80 millimeters, and y7=1.50 millimeters.

It should be noted that, in the embodiment of the present invention, the size of the plug body 11, the distance between the first row of slots 12 and the second row of slots 13, the distance between every two adjacent slots of the first row of slots 12, the distance between every two adjacent slots of the second row of slots 13, the size of the first pin 14, and the size of the second pin 15 are merely used as examples for description, and no specific limitation is imposed on the size of the plug body 11, the distance between the first row of slots 12 and the second row of slots 13, the distance between every two adjacent slots of the first row of slots 12, the distance between every two adjacent slots of the second row of slots 13, the size of the first pin 14, and the size of the second pin 15 in the embodiment of the present invention.

It should be noted that, in the embodiment of the present invention, the number of slots of the first row of slots 12 is the same as the number of first pins 14, the number of slots of the second row of slots 13 is the same as the number of second pins 15, and in the embodiment of the present invention, no limitation is imposed on the number of slots of the first row of slots 12 and the number of first pins 14 herein, and no limitation is imposed on the number of slots of the second row of slots 13 and the number of second pins 15 either herein.

For ease of understanding by a person skilled in the art, in the embodiment of the present invention, exemplarily, the first row of slots 12 disposed on the plug body 11 shown in FIG. 4 includes 8 slots, the second row of slots 13 also includes 8 slots, and the plug 10 shown in FIG. 3 includes 8 first pins 14 and 8 second pins 15.

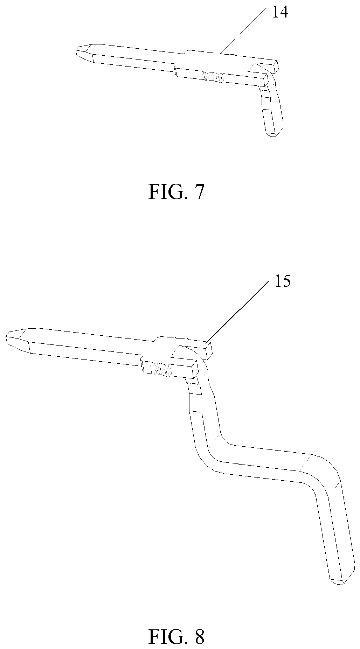

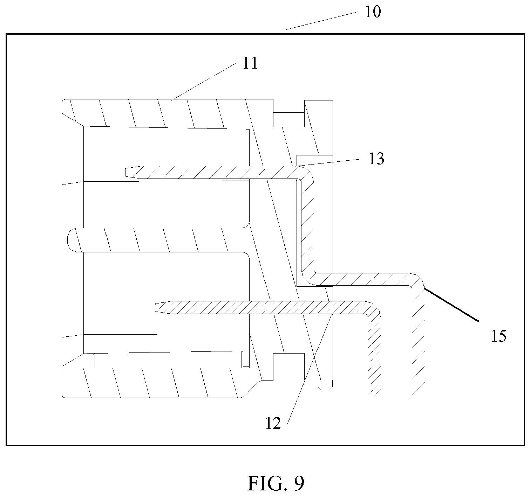

FIG. 7 is a schematic diagram of a first pin 14 according to an embodiment of the present invention. The first pin 14 shown in FIG. 7 is L-shaped. FIG. 8 is a schematic diagram of a second pin 15 according to an embodiment of the present invention. The second pin 15 shown in FIG. 8 is a stair-shaped pin obtained after being bent twice. FIG. 9 is a cross-sectional view of a plug 10 according to an embodiment of the present invention. As shown in FIG. 9, one end of each first pin 14 of the 8 first pins 14 is embedded in a slot, in a corresponding position, of 8 slots included in the first row of slots 12, and the other end is configured to connect to the first PCB. In a possible implementation manner, one end of the first pin 14 may be connected to the first PCB by welding. As shown in FIG. 9, one end of each second pin 15 of the 8 second pins 15 is embedded in a slot, in a corresponding position, of 8 slots included in the second row of slots 13, and the other end is configured to connect to the first PCB, is parallel to the end, which is connected to the first PCB, of the first pin 14, and is located on an outer side of the end, which is connected to the first PCB, of the first pin 14. In a possible implementation manner, one end of the second pin 15 may be connected to the first PCB by welding.

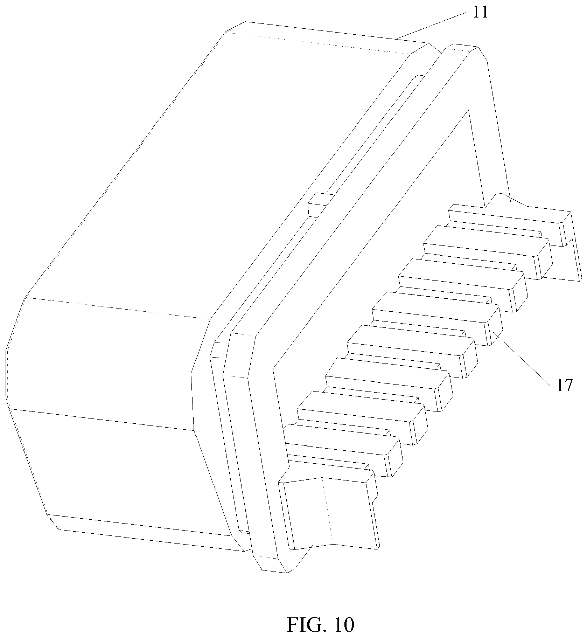

In another embodiment of the present invention, FIG. 10 is a schematic diagram of composition of a plug body 11 according to an embodiment of the present invention. Clamping slots 17 in one-to-one correspondence with the second row of slots 13 are further disposed on the plug body 11 shown in FIG. 10, and the clamping slot 17 is configured to correct a position deviation of the second pin 15.

Exemplarily, a connection manner of the clamping slot 17 and the plug body 11 may be a fixed connection, for example, the clamping slot 17 is connected to the plug body 11 by welding, the clamping slot 17 and the plug body 11 may also be integrally formed, and in the embodiment of the present invention, no specific limitation is imposed on the connection manner of the clamping slot 17 and the plug body 11 herein. A connection manner of the clamping slot 17 and the second pin 15 may be clamping, and may also be another connection manner, and in the embodiment of the present invention, no specific limitation is imposed on the connection manner of the clamping slot 17 and the second pin 15 either herein.

Exemplarily, in the embodiment of the present invention, a distance between every two clamping slots 17 of the clamping slots 17 in one-to-one correspondence with the second row of slots 13 may be 4.00 millimeters.

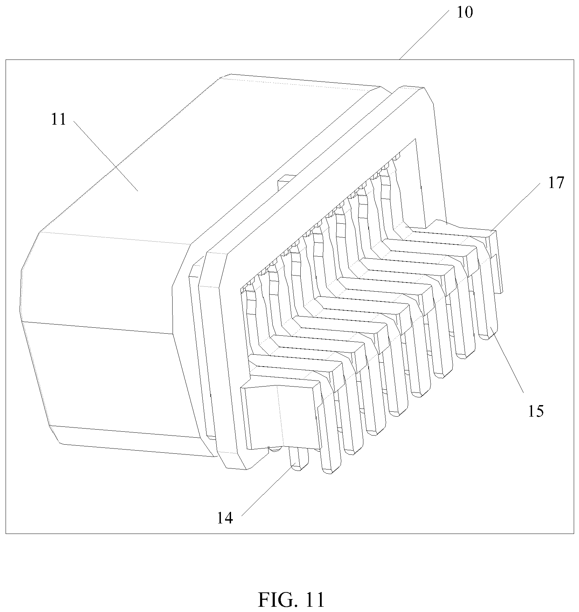

Exemplarily, FIG. 11 is a diagram of an overall structure of a plug 10 including first pins 14, second pins 15, and clamping slots 17. The clamping slots 17 may correct position deviations of the second pins 15, so that angles of all the second pins 15 are kept consistent, thereby facilitating assembly.

According to the plug provided in the embodiment of the present invention, the plug includes a plug body, where a first row of slots and a second row of slots are disposed on the plug body, and the first row and the second row are parallel; the plug further includes first pins in one-to-one correspondence with the first row of slots and second pins in one-to-one correspondence with the second row of slots, the first pin is L-shaped, and the second pin is stair-shaped. The second pin is stair-shaped, and therefore a second PCB may be disposed above the second pin, so that components of the second PCB may be arranged by maximizing use of space, thereby reducing a volume of a printed circuit board assembly.

In addition, clamping slots in one-to-one correspondence with the second row of slots are disposed on the plug body of the plug, so that a position deviation that may be caused after the second pin is bent is corrected.

### Embodiment 2

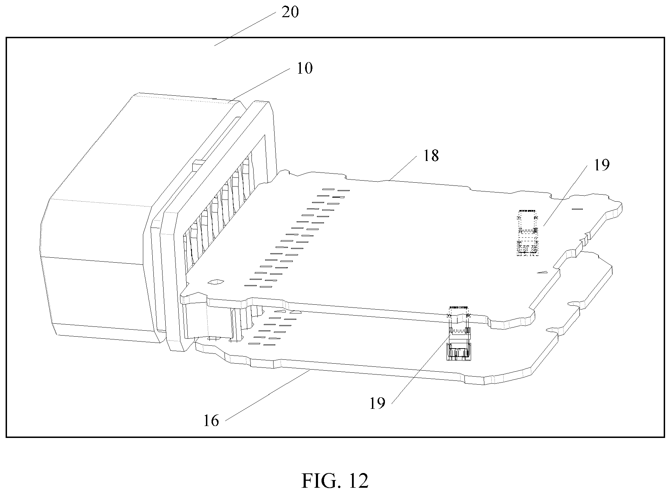

Embodiment 2 of the present invention provides a printed circuit board assembly 20. As shown in FIG. 12, the printed circuit board assembly 20 may include: a plug 10 shown in FIG. 3 and a first PCB 16.

The first PCB 16 is configured to connect to one end of a first pin 14 of the plug 10 and connect to one end of a second pin 15 of the plug 10. In a possible implementation manner, one end of the first pin 14 may be connected to the first PCB 16 by welding, and one end of the second pin 15 may be connected to the first PCB 16 by welding.

It should be noted that, for a specific description of the plug 10 in the embodiment of the present invention, reference may be made to a specific description of the plug 10 in Embodiment 1 of the present invention, and details are not described herein again in the embodiment of the present invention.

In the embodiment of the present invention, optionally, as shown in FIG. 12, the printed circuit board assembly 20 may further include: a second PCB 18.

The second PCB 18 is connected to the first PCB 16 by using a connector 19, and the second pin 15 of the plug 10 is located between the first PCB 16 and the second PCB 18.

It should be noted that FIG. 12 merely shows an exemplary structure of the connector 19, and no limitation is imposed on specific composition of the connector 19 herein in the embodiment of the present invention.

In the embodiment of the present invention, further, optionally, as shown in FIG. 12, one end of the second PCB 18 is closely adjacent to the plug body 11 of the plug 10. Because the second pin 15 is stair-shaped, the second PCB 18 may be disposed at a position shown in FIG. 12, so that components of the second PCB 18 may be arranged by maximizing use of space, thereby reducing a volume of the printed circuit board assembly 20.

The printed circuit board assembly provided in the embodiment of the present invention includes a plug, where the plug includes a plug body, a first row of slots and a second row of slots are disposed on the plug body, and the first row and the second row are parallel; the plug further includes first pins in one-to-one correspondence with the first row of slots and second pins in one-to-one correspondence with the second row of slots, the first pin is L-shaped, and the second pin is stair-shaped. The second pin is stair-shaped, and therefore a second PCB may be disposed above the second pin, so that components of the second PCB may be arranged by maximizing use of space, thereby reducing a volume of the printed circuit board assembly.

In addition, clamping slots in one-to-one correspondence with the second row of slots are disposed on the plug body of the plug, so that a position deviation that may be caused after the second pin is bent is corrected.

## Claims

1. A plug (10) comprising a plug body (11),
• wherein a first row (12) of slots and a second row (13) of slots are disposed on the plug body (11), and the first row (12) and the second row (13) are parallel; and the plug (10) further comprises first pins (14) in one-to-one correspondence with the first row (12) of slots and second pins (15) in one-to-one correspondence with the second row (13) of slots; wherein
• the first pin (14) comprises:
∘ a first straight portion, a second straight portion, and a bent portion, wherein the bent portion connects the first straight portion to the second straight portion, so that the first pin (14) is L-shaped,
∘ wherein the first straight portion of the first pin (14) is embedded in a slot, in a corresponding position, of the first row (12) of slots, and the second straight portion is configured to connect to a first printed circuit board , PCB, (16); and
• the second pin (15) comprising:
∘ a first straight portion, a second straight portion, a third straight portion, a fourth straight portion, a first bent portion, a second bent portion and a third bent portion, wherein the first bent portion connects the first straight portion to the second straight portion, the second bent portion connects the second straight portion to the third straight portion and the third bent portion connects the third straight portion to the fourth straight portion, so that the second pin (15) is stair-shaped,
∘ wherein the first straight portion of the second pin (15) is embedded in a slot, in a corresponding position, of the second row (13) of slots, and
the fourth straight portion of the second pin (15) is configured to connect to the first PCB (16) and is parallel to the second straight portion of the first pin (14),
wherein the second straight portion of the first pin (14) has an inner side facing the plug body (11) and an outer side facing away from the plug body (11) **characterized in that** the fourth straight portion of the second pin (15) has an inner side facing the outer side of the second straight portion of the first pin (14) and an outer side facing away from the plug body (11).

2. The plug (10) according to claim 1, wherein
clamping slots in one-to-one correspondence with the second row (13) of slots are further disposed on the plug body (11), and the clamping slot (17) is configured to correct a position deviation of the second pin (15).

3. A printed circuit board assembly (20), comprising:
the plug (10) according to any one of claims 1 to 2; and
a first printed circuit board PCB (16), wherein
the first PCB (16) is configured to connect to the second straight portion of the first pin (14) of the plug and connect to the fourth straight portion of the second pin (15) of the plug (10).

4. The printed circuit board assembly (20) according to claim 3, further comprising a second PCB (18), wherein
the second PCB (18) is connected to the first PCB (16) by using a connector (19), and the second pin (15) of the plug (10) is located between the first PCB (16) and the second PCB (18).

5. The printed circuit board assembly (20) according to claim 4, wherein
one end of the second PCB (18) is closely adjacent to the plug body (11) of the plug (10).

## Patentansprüche

1. Stecker (10), umfassend einen Übergangsstecker (11),
• wobei eine erste Reihe (12) von Schlitzen und eine zweite Reihe (13) von Schlitzen auf dem Übergangsstecker (11) eingerichtet sind und die erste Reihe (12) und die zweite Reihe (13) parallel sind; und der Stecker (10) ferner erste Stifte (14) in einer Eins-zu-Eins-Entsprechung mit der ersten Reihe (12) von Schlitzen und zweite Stifte (15) in einer Eins-zu-Eins-Entsprechung mit der zweiten Reihe (13) von Schlitzen umfasst; wobei
• der erste Stift (14) Folgendes umfasst:
∘ einen ersten geraden Abschnitt, einen zweiten geraden Abschnitt und einen gebogenen Abschnitt, wobei der gebogene Abschnitt den ersten geraden Abschnitt mit dem zweiten geraden Abschnitt verbindet, sodass der erste Stift (14) L-förmig ist,
∘ wobei der erste gerade Abschnitt des ersten Stifts (14) in einem Schlitz der ersten Reihe (12) von Schlitzen in einer entsprechenden Position eingebettet ist und der zweite gerade Abschnitt konfiguriert ist, um sich mit einer ersten Leiterplatte (*printed circuit board* - PCB) (16) zu verbinden; und
• der zweite Stift (15) Folgendes umfasst:
∘ einen ersten geraden Abschnitt, einen zweiten geraden Abschnitt, einen dritten geraden Abschnitt, einen vierten geraden Abschnitt, einen ersten gebogenen Abschnitt, einen zweiten gebogenen Abschnitt und einen dritten gebogenen Abschnitt, wobei der erste gebogene Abschnitt den ersten geraden Abschnitt mit dem zweiten geraden Abschnitt verbindet, der zweite gebogene Abschnitt den zweiten geraden Abschnitt mit dem dritten geraden Abschnitt verbindet und der dritte gebogene Abschnitt den dritten geraden Abschnitt mit dem vierten geraden Abschnitt verbindet, sodass der zweite Stift (15) treppenförmig ist,
∘ wobei der erste gerade Abschnitt des zweiten Stifts (15) in einem Schlitz der zweiten Reihe (13) von Schlitzen in einer entsprechenden Position eingebettet ist und der vierte gerade Abschnitt des zweiten Stifts (15) konfiguriert ist, um sich mit der ersten PCB (16) zu verbinden, und parallel zu dem zweiten geraden Abschnitt des ersten Stifts (14) verläuft, wobei der zweite gerade Abschnitt des ersten Stifts (14) eine dem Übergangsstecker (11) zugewandte Innenseite und eine von dem Übergangsstecker (11) abgewandte Außenseite aufweist, **dadurch gekennzeichnet, dass** der vierte gerade Abschnitt des zweiten Stifts (15) eine der Außenseite des zweiten geraden Abschnitts des ersten Stifts (14) zugewandte Innenseite und eine von dem Übergangsstecker (11) abgewandte Außenseite aufweist.

2. Stecker (10) nach Anspruch 1, wobei Klemmschlitze in einer Eins-zu-Eins-Entsprechung mit der zweiten Reihe (13) von Schlitzen ferner auf dem Übergangsstecker (11) eingerichtet sind und der Klemmschlitz (17) konfiguriert ist, um eine Positionsabweichung des zweiten Stifts (15) zu korrigieren.

3. Leiterplattenanordnung (20), Folgendes umfassend:
den Stecker (10) nach einem der Ansprüche 1 bis 2; und
eine erste Leiterplatte (PCB) (16), wobei die erste PCB (16) konfiguriert ist, um sich mit dem zweiten geraden Abschnitt des ersten Stifts (14) des Steckers zu verbinden und sich mit dem vierten geraden Abschnitt des zweiten Stifts (15) des Steckers (10) zu verbinden.

4. Leiterplattenanordnung (20) nach Anspruch 3, ferner umfassend eine zweites PCB (18), wobei die zweite PCB (18) mit der ersten PCB (16) durch Verwenden eines Verbindungsstücks (19) verbunden ist, und der zweite Stift (15) des Steckers (10) sich zwischen der ersten PCB (16) und der zweiten PCB (18) befindet.

5. Leiterplattenanordnung (20) nach Anspruch 4, wobei ein Ende der zweiten PCB (18) eng an den Übergangsstecker (11) des Steckers (10) angrenzt.

## Revendications

1. Fiche (10) comprenant un corps de fiche (11),
• dans laquelle une première rangée (12) de fentes et une seconde rangée (13) de fentes sont disposées sur le corps de fiche (11), et la première rangée (12) et la seconde rangée (13) sont parallèles ; et la fiche (10) comprend en outre des premières broches (14) en correspondance une à une avec la première rangée (12) de fentes et des secondes broches (15) en correspondance une à une avec la seconde rangée (13) de fentes ; dans laquelle
• la première broche (14) comprend :
∘ une première partie droite, une deuxième partie droite et une partie courbée, dans laquelle la partie courbée connecte la première partie droite à la deuxième partie droite, de sorte que la première broche (14) est en forme de L,
∘ dans laquelle la première partie droite de la première broche (14) est encastrée dans une fente, dans une position correspondante de la première rangée (12) de fentes, et la deuxième partie droite est conçue pour se connecter à une première carte de circuit imprimé, PCB, (16) ; et
• la seconde broche (15) comprenant:
∘ une première partie droite, une deuxième partie droite, une troisième partie droite, une quatrième partie droite, une première partie courbée, une deuxième partie courbée et une troisième partie courbée, dans laquelle la première partie courbée connecte la première partie droite à la deuxième partie droite, la deuxième partie courbée connecte la deuxième partie droite à la troisième partie droite et la troisième partie courbée connecte la troisième partie droite à la quatrième partie droite, de sorte que la seconde broche (15) est en forme d'escalier,
∘ dans laquelle la première partie droite de la seconde broche (15) est encastrée dans une fente, dans une position correspondante de la seconde rangée (13) de fentes, et la quatrième partie droite de la seconde broche (15) est conçue pour se connecter à la première PCB (16) et est parallèle à la deuxième partie droite de la première broche (14), dans laquelle la deuxième partie droite de la première broche (14) a une face interne tournée vers le corps de fiche (11) et une face externe tournée à l'opposé du corps de fiche (11), **caractérisée en ce que** la quatrième partie droite de la seconde broche (15) a une face interne tournée vers la face externe de la deuxième partie droite de la première broche (14) et une face externe tournée à l'opposé du corps de fiche (11).

2. Fiche (10) selon la revendication 1, dans laquelle des fentes de serrage en correspondance une à une avec la seconde rangée (13) de fentes sont en outre disposées sur le corps de fiche (11) et la fente de serrage (17) est conçue pour corriger une déviation de position de la seconde broche (15).

3. Ensemble de carte de circuit imprimé (20), comprenant :
la fiche (10) selon l'une quelconque des revendications 1 à 2 ; et
une première carte de circuit imprimé (16) PCB, dans laquelle la première PCB (16) est conçue pour se connecter à la deuxième partie droite de la première broche (14) de la fiche et se connecter à la quatrième partie droite de la seconde broche (15) de la fiche (10).

4. Ensemble de carte de circuit imprimé (20) selon la revendication 3, comprenant en outre une seconde PCB (18), dans lequel la seconde PCB (18) est connectée à la première PCB (16) en utilisant un connecteur (19), et la seconde broche (15) de la fiche (10) est située entre la première PCB (16) et la seconde PCB (18).

5. Ensemble de carte de circuit imprimé (20) selon la revendication 4, dans lequel une extrémité de la seconde PCB (18) est étroitement adjacente au corps de fiche (11) de la fiche (10).
